# EUROPEAN PATENT APPLICATION

(11) **EP 4 679 949 A1**
(43) Date of publication of application: **14.01.2026**
(21) Application number: 24924249.6
(22) Date of filing: 22.07.2024
(51) Int. Cl.: H05K 5/06, H02M 1/00

(54) **POWER CONVERSION DEVICE AND MANUFACTURING METHOD THEREFOR**

(30) Priority: 23.05.2024 CN 202410653981
(71) Applicant: Shanghai Moorewatt Energy Technology Co., Ltd., Shanghai 200131 (CN)
(72) Inventor: YU, Yinfei, Shanghai 200131 (CN)
(74) Representative: Ipsilon
(86) International application number: PCT/CN2024/106783
(87) International publication number: WO 2025/241298

(57) **Abstract**

A power conversion device (10) includes: a housing (100) enclosing an accommodation cavity (130), the housing (100) being provided with a filling port (1111) and a vent port (1121), the filling port (1111) and the vent port (1121) being in communication with the accommodation cavity (130); and a circuit board (200) disposed in the accommodation cavity (130), the circuit board (200) having a first surface (210) configured for mounting of electronic components. The filling port (1111) is closer to the first surface (210) than the vent port (1121).

## Description

### RELATED APPLICATIONS

This application claims priority to Chinese Patent Application No. 2024106539813, entitled "POWER CONVERSION DEVICE AND MANUFACTURING METHOD THEREOF," filed on May 23, 2024, the disclosure of which is incorporated herein by reference in its entity.

### TECHNICAL FIELD

The present application relates to the field of new energy technology, and in particular, to a power conversion device and a manufacturing method thereof.

### BACKGROUND

With the rapid development of new energy technology, solar energy has been widely applied in daily production and life due to its advantages such as being pollution-free and sustainably utilizable. Generally, solar light energy can be converted into electrical energy through photovoltaic power generation technology. The direct current generated by photovoltaic power generation technology is converted into alternating current through a power conversion device. This alternating current can become usable electrical energy and be fed into the grid through a connector. To enable the power conversion device to be used in various harsh environments, potting liquid is usually required to be injected into the power conversion device to provide sealing and protective effects. However, conventional power conversion devices usually have the defect of uneven filling of the potting liquid.

### SUMMARY

One of the technical problems solved by the present application is how to improve the potting uniformity of the power conversion device.

A first aspect of the present application provides a power conversion device, including:
a housing enclosing an accommodation cavity, the housing being provided with a filling port and a vent port, the filling port and the vent port being in communication with the accommodation cavity; and
a circuit board disposed in the accommodation cavity, the circuit board having a first surface configured for mounting of electronic components, where the filling port is closer to the first surface than the vent port.

A second aspect of the present application provides a manufacturing method for processing the power conversion device as described above, including the following steps:
disposing the power conversion device at a first angle with a horizontal plane as a reference plane, where the filling port is lower in a vertical direction than the vent port;
injecting potting liquid into the accommodation cavity via the filling port; and
sealing the filling port and the vent port.

Details of one or more embodiments of the present application are set forth in the accompanying drawings and description below. Other features, objects, and advantages of the present invention will become apparent from the specification, drawings, and claims.

### BRIEF DESCRIPTION OF THE DRAWINGS

To better describe and illustrate the embodiments and/or examples of the inventions disclosed herein, reference may be made to one or more drawings. Additional details or examples used to describe the drawings should not be considered as limiting the scope of any of the disclosed inventions, currently described embodiments and/or examples, and the best mode of the inventions currently understood.
FIG.1 is a schematic perspective view of a power conversion device according to a first prior art.
FIG. 2 is a schematic perspective view of a power conversion device according to a second prior art.
FIG. 3 is a schematic perspective view of a power conversion device according to an embodiment.
FIG. 4 is a schematic perspective view of the power conversion device shown in FIG. 3 from another perspective.
FIG. 5 is a schematic exploded view of a first example of the power conversion device shown in FIG. 3.
FIG. 6 is a schematic exploded view of a second example of the power conversion device shown in FIG. 3.
FIG. 7 is an enlarged schematic view of portion A in FIG. 6.
FIG. 8 is a schematic perspective section view of the power conversion device shown in FIG. 3.
FIG. 9 is a schematic plan view of the power conversion device shown in FIG. 3.
FIG. 10 is a schematic perspective view of the power conversion device shown in FIG. 3 that is tilted relative to a horizontal plane.
FIG. 11 is a flowchart block diagram of a manufacturing method for the power conversion device shown in FIG. 3 according to an embodiment.

### DETAILED DESCRIPTION

To make the above objects, features, and advantages of the present application more comprehensible, the specific implementations of the present application are described in detail below with reference to the accompanying drawings. Many specific details are set forth in the following description to facilitate a full understanding of the present application. However, the present application can be implemented in many other ways different from those described herein. Those skilled in the art can make similar improvements without departing from the spirit of the present application. Therefore, the present application is not limited by the specific embodiments disclosed below.

In the description of the present application, it should be understood that if terms such as "center," "longitudinal," "transverse," "length," "width," "thickness," "upper," "lower," "front," "rear," "left," "right," "vertical," "horizontal," "top," "bottom," "inner," "outer," "clockwise," "counterclockwise," "axial," "radial," "circumferential," etc., appear, orientation or position relationships indicated by these terms are based on the orientation or position relationships shown in the drawings, and are only for the convenience of describing the present application and simplifying the description, rather than indicating or implying that the device or element referred to must have a specific orientation, be constructed and operated in a specific orientation. Therefore, they should not be construed as limitations on the present application.

Furthermore, if terms such as "first," "second," appear, these terms are used for descriptive purposes only and should not be construed as indicating or implying relative importance or implicitly specifying the number of the indicated technical features. Thus, features defined with "first," "second," may explicitly or implicitly include at least one of such features. In the description of the present application, if the term "plurality" appears, it means at least two, such as two, three, etc., unless otherwise explicitly and specifically limited.

In the present application, unless otherwise explicitly specified and limited, if terms such as "mounting," "connecting," "coupling," "fixing," etc., appear, these terms should be understood in a broad sense. For example, it may be a fixed connection, a detachable connection, or an integral connection; it may be a mechanical connection, or an electrical connection; it may be a direct connection, an indirect connection through an intermediate medium, or an internal connection between two elements or an interaction between two elements, unless otherwise explicitly limited. For those of ordinary skill in the art, the specific meanings of the above terms in the present application can be understood according to specific circumstances.

In the present application, unless otherwise explicitly specified and limited, if descriptions such as a first feature being "on" or "under" a second feature appear, the meaning may be that the first feature and second feature are in direct contact, or the first feature and second feature are in indirect contact through an intermediate medium. Moreover, the first feature being "over," "above," or "on" the second feature may mean the first feature is directly above or obliquely above the second feature, or merely indicates that the height of the first feature is higher in level than the second feature. The first feature being "under," "below," or "underneath" the second feature may mean the first feature is directly below or obliquely below the second feature, or merely indicates that the height of the first feature is lower in level than the second feature.

It should be noted that if an element is referred to as being "fixed to" or "disposed on" another element, it may be directly on the other element or intervening elements may be present. If an element is considered to be "connected" to another element, it may be directly connected to the other element or intervening elements may be present at the same time. If terms such as "vertical," "horizontal," "upper," "lower," "left," "right," and similar expressions appear, these terms used in the present application are for illustrative purposes only and do not represent the only implementations.

In the field of photovoltaic power generation technology, the direct current generated by photovoltaic power generation is converted into alternating current through a power conversion device. This alternating current can become usable electrical energy that can be directly fed into the grid or be stored by an energy storage device. To enable the power conversion device to be used in various harsh environments, it is not only necessary to seal the outer housing of the power conversion device but also usually required to inject potting liquid into the power conversion device to seal electronic components inside the power conversion device, thereby providing protection.

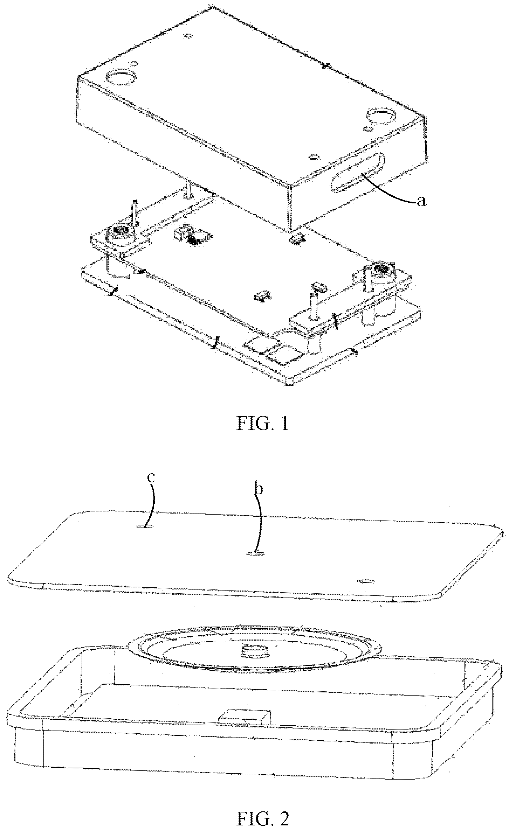

In the prior art shown in FIG. 1, the filling port *a* is arranged on a side of a housing, making the filling port *a* far from the side of the power conversion device opposite to the filling port *a.* This causes difficulty in effectively filling the side opposite to the filling port *a* within the power conversion device with potting liquid, thereby making it difficult to ensure the uniformity of potting. In the prior art shown in FIG. 2, the filling port b and the vent port c are both on the same plane, and the vent port c is located in the middle of the housing of the power conversion device. This will make it difficult for air within the power conversion device to gather at the vent port c to be discharged, thereby affecting the uniformity of potting due to air remained in the power conversion device.

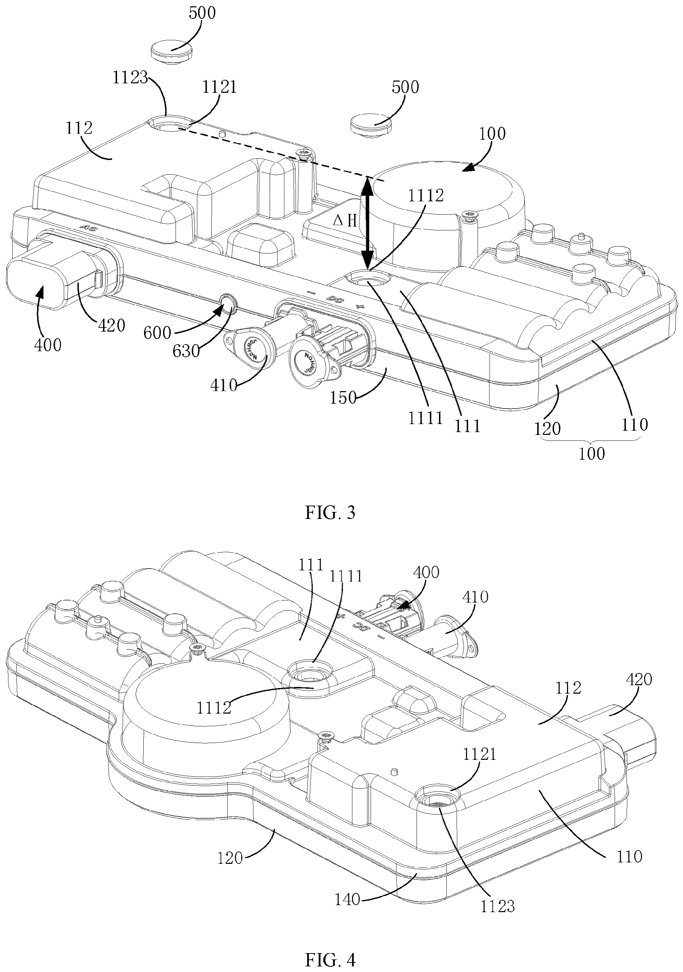

Referring to FIG. 3, FIG. 5, and FIG. 6, a power conversion device 10 provided in an embodiment of the present application includes a housing 100 and a circuit board 200. The housing 100 encloses an accommodation cavity 130. The circuit board 200 is disposed within the accommodation cavity 130. The housing 100 is provided with a filling port 1111 and a vent port 1121. Both the filling port 1111 and the vent port 1121 are in communication with the accommodation cavity 130. The circuit board 200 has a first surface 210 and a second surface 220. The first surface 210 and the second surface 220 are two surfaces opposite to each other in a direction perpendicular to the first surface. In the direction perpendicular to the first surface, the first surface 210 faces the filling port 1111 and the vent port 1121. The first surface 210 is also configured for mounting of other electronic components. In the direction perpendicular to the first surface, the filling port 1111 is closer to the first surface 210 than the vent port 1121.

In a possible implementation, as shown in FIG. 3, the filling port 1111 and the vent port 1121 may be spaced apart by ΔH in the direction perpendicular to the first surface. The value of ΔH may range from 10 mm to 15 mm, for example, ΔH may specifically be 10 mm, 12.5 mm, or 15 mm, etc.

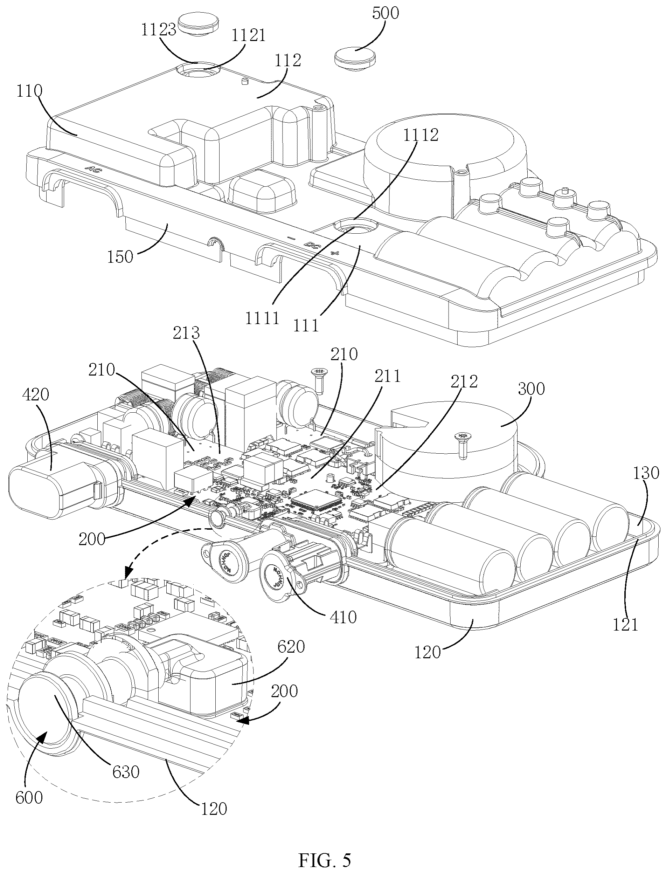

As shown in FIG. 5, the power conversion device 10 further includes a transformer 300. The transformer 300 may be disposed on the first surface 210. Potting liquid can be injected into the accommodation cavity 130 via the filling port 1111. The cured potting liquid can provide sealing and protective effects for the housing 100 and electronic components, thereby ensuring that the power conversion device 10 can be applied in various harsh environments such as humidity, heat, acid, alkali, rain, snow, and freezing, and can also improve the impact resistance of the power conversion device 10. During the process of injecting potting liquid via the filling port 1111, air within the accommodation cavity 130 will gradually be discharged from the vent port 1121.

The potting liquid may be an electrically insulating material, for example, the potting liquid may be an adhesive made of silicone material, etc. as such, this gives the cured potting liquid good elasticity to withstand significant stress. It can be understood that any material having electrical insulation properties and elasticity after be cured can be used as the potting liquid.

Since the filling port 1111 is closer to the first surface 210 than the vent port 1121, during the process of filling the accommodation cavity 130 with potting liquid, the liquid level formed by the potting liquid within the accommodation cavity 130 will finally reach the vent port 1121. This avoids the liquid level from reaching the vent port 1121 before the accommodation cavity 130 is completely filled with potting liquid and from blocking the vent port 1121, preventing the vent port 1121 from being blocked and unable to effectively discharge air, thereby ensuring that all air within the accommodation cavity 130 can be discharged to the outside via the vent port 1121, avoiding air remained in the accommodation cavity 130 from affecting the uniformity of the filling of the potting liquid, that is, improving potting uniformity.

Referring to FIG. 3, FIG. 4, and FIG. 9, in some embodiments, the housing 100 has a first corner region 140. Two side edges of the housing 100 intersect at this first corner region 140. It can be understood that the portion within a predetermined distance from the intersection line of the two side edges of the housing 100 belongs to the first corner region 140. The two side edges of the housing 100 are respectively referred to as a first side edge 101 and a second side edge 102 of the housing 100. For example, the position on the housing 100 that is within a range of 20 mm to 30 mm from the first side edge 101 and within a range of 20 mm to 35 mm from the second side edge 102 belongs to the first corner region 140. The predetermined distance from the first side edge 101 may specifically be 20 mm or 25 mm, etc. The predetermined distance from the second side edge 102 may specifically be 25 mm or 30 mm, etc. The length of the first side edge 101 may be greater than the length of the second side edge 102, that is, the first side edge 101 is the long side and the second side edge 102 is the short side. Certainly, the lengths of the first side edge 101 and the second side edge 102 may also be equal to each other.

The vent port 1121 is disposed at a position adjacent to the first corner region 140. For example, the center of the vent port 1121 may be located within the first corner region 140. For another example, at least a portion of the vent port 1121 may be located within the first corner region 140. The vent port 1121 may be circular, etc. As such, during the process of filling the accommodation cavity 130 with potting liquid, since the first corner region 140 is an intersection of two directions, air from various positions within the accommodation cavity 130 can more easily converge to this first corner region 140 from different directions, thereby resulting in relatively higher air pressure near the vent port 1121, ensuring that air is quickly discharged from the vent port 1121, which can avoid air from remaining in the accommodation cavity 130 and avoid the remained air from affecting the uniformity of the filling of the potting liquid, and ultimately improving potting uniformity.

Referring to FIG. 4, FIG. 5, and FIG. 6, in some embodiments, the housing 100 may be of a conformal structure. The housing 100 may be made of plastic or other electrically insulating materials. The first surface 210 of the circuit board 200 is arranged to face the conformal structure in the direction perpendicular to the first surface. The conformal structure can be understood as an uneven structure adapted to accommodate electronic components protruding by different heights relative to the circuit board 200 within the cavity 130. For example, the conformal structure may be a rough structure, that is, a certain local portion of the housing 100 is disposed at a predetermined height from the circuit board 200 to accommodate multiple electronic components protruding within a certain height range relative to the circuit board 200. For another example, the conformal structure may be a fine structure, that is, different local portions of the housing 100 are disposed at predetermined heights from the circuit board 200 to accommodate each of the electronic components protruding by different heights relative to the circuit board 200. By providing the conformal structure, the amount of potting liquid used can be saved.

The conformal structure may have rounded corners, which can improve the uniformity of flow rate of the potting liquid, avoid air from remaining within the accommodation cavity 130 and avoid the remained air from affecting the uniformity of the filling of the potting liquid, and thereby prevent voids from forming in the solid body formed after the potting liquid is cured.

Continuing to refer to FIG. 4, FIG. 5, and FIG. 6, the conformal structure includes a first region 111 and a second region 112. The first region 111 is closer to the first surface 210 than the second region 112. This can be generally understood as the first region 111 being lower than the second region 112 in the vertical direction. The filling port 1111 is disposed in the first region 111. The vent port 1121 is disposed in the second region 112, so that the filling port 1111 is closer to the first surface 210 than the vent port 1121, and the filling port 1111 is lower than the vent port 1121. The vent port 1121 is disposed at a position in the second region 112 adjacent to the first corner region 140. In this way, the air is allowed to be quickly discharged from the vent port 1121, and is avoided from remaining in the accommodation cavity 130, thereby improving potting uniformity.

Referring to FIG. 4, FIG. 5, FIG. 6, and FIG. 9, in some embodiments, the first region 111 includes a second corner region 1112. Two side edges of the first region 111 intersect at this second corner region 1112. It can be understood that the portion within a predetermined distance from the intersection line of the two side edges of the first region 111 belongs to the second corner region 1112. The two side edges of the first region 111 are respectively referred to as a third side edge 103 and a fourth side edge 104 of the first region 111. For example, the position on the first region 111 that is within a range of 10 mm to 20 mm from the third side edge 103 and within a range of 15 mm to 25 mm from the fourth side edge 104 belongs to the second corner region 1112. The predetermined distance from the third side edge 103 may specifically be 15 mm or 20 mm, etc. The predetermined distance from the fourth side edge 104 may specifically be 20 mm or 25 mm, etc.

The filling port 1111 is disposed at a position adjacent to the second corner region 1112. For example, the center of the filling port 1111 may be located in the second corner region 1112. For another example, at least a portion of the filling port 1111 may be located in the second corner region 1112. The filling port 1111 may be circular, but may also be square or regular polygonal, etc. The second corner region 1112 has a rounded corner. By providing the rounded corner to avoid dead angles, it will facilitate to improve the fluidity of the potting liquid in the accommodation cavity 130. On one hand, this allows the potting liquid to quickly fill the accommodation cavity 130, improving potting efficiency. On the other hand, it facilitates the rapidly flowing potting liquid to squeeze out the air from the accommodation cavity 130 through the vent port 1121, thereby avoiding the remained air from affecting potting uniformity. When the filling port 1111 is circular, the circular filling port 1111 matches with the rounded corner, which can save area of the housing 100 and also make the housing 100 easier to process.

Referring to FIG. 4, FIG. 5, and FIG. 6, the second region 112 includes a third corner region 1123. The two side edges of the second region 112 intersect at this third corner region 1123. It can be understood that the portion within a predetermined distance from the intersection line of the two side edges of the second region 112 belongs to the third corner region 1123. The definition of the third corner region 1123 can refer to the aforementioned second corner region 1112. The vent port 1121 is disposed at the third corner region 1123, so that air in the accommodation cavity 130 is also more likely to converge to this third corner region 1123, avoiding air from being remaining in the accommodation cavity 130 and avoiding the remained air from affecting the uniformity of the filling of the potting liquid filling, and ultimately improving potting uniformity.

Referring to FIG. 4, FIG. 5, and FIG. 6, since the filling port 1111 is disposed in the first region 111 and the vent port 1121 is disposed in the second region 112, a predetermined distance is kept between the center of the filling port 1111 and the center of the vent port 1121. The predetermined distance is in a range of 120 mm to 140 mm. The predetermined distance may specifically be 120 mm, 130 mm, or 140 mm, etc. With such arrangement of the filling port 1111 and the vent port 1121, it also facilitates an appropriate flow distance for the potting liquid, thereby optimizing the air venting effect, and ultimately improving potting uniformity.

Exemplarily, the diameters of the filling port 1111 and the vent port 1121 may be in a range of 5 mm to 15 mm. The diameters of the filling port 1111 and the vent port 1121 may not be equal to each other. For example, the diameter of the filling port 1111 may be less than the diameter of the vent port 1121. This makes the vent port 1121 have a relatively large diameter, which facilitates reducing the flow resistance of air flowing through the vent port 1121, thereby improving the air venting effect, and ultimately improving potting uniformity.

Referring to FIG. 5, in some embodiments, the first surface 210 of the circuit board 200 has a blank region 211. The blank region 211 has no electronic components mounted thereon. An orthographic projection of the filling port 1111 along the direction perpendicular to the first surface falls within the blank region 211. This can be understood as the filling port 1111 being directly above the blank region 211, causing the filling port 1111 to be offset from the electronic components on the circuit board 200. This prevents potting liquid flowing out of the filling port 1111 from directly falling onto electronic components, thereby preventing the pressure of the potting liquid from directly exerting on the electronic components and causing damage to the electronic components, and ultimately improving potting safety.

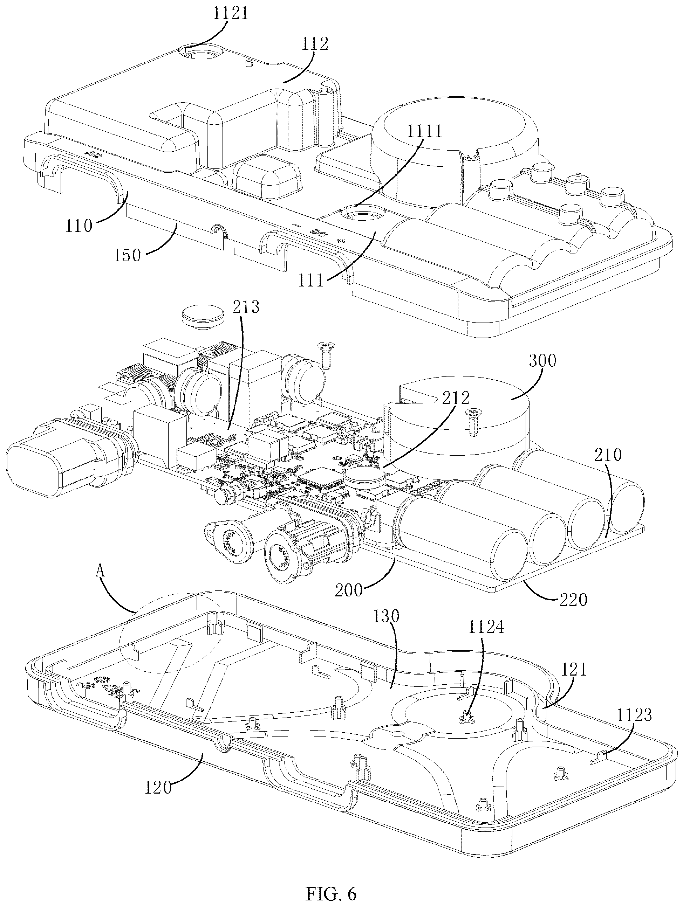

Referring to FIG. 5 and FIG. 6, in some embodiments, the first surface 210 has a direct current (DC) region 212 and an alternate current (AC) region 213. The DC region 212 is configured for mounting of direct current (DC) electronic components. The DC electronic components are devices on a DC side. Certainly, the AC electronic components may also be mounted on the DC region 212. The DC electronic components usually rarely have encapsulation housings, so most DC electronic components are bare electronic components. The AC region 213 is configured for mounting of alternate current (AC) electronic components. The AC electronic components are devices on an AC side. The AC electronic components usually have encapsulation housings, so most AC electronic components are encapsulated electronic components.

Since most DC electronic components are bare electronic components, the orthographic projection of the filling port 1111 along the direction perpendicular to the first surface 210 can fall in the DC region 212, that is, the filling port 1111 is located directly above the DC region 212 and the DC electronic components. In this way, the potting liquid flowing out of the filling port 1111 is allowed to cover the DC region 212 and the DC electronic components earlier and more abundantly, causing air to flow out of the DC region 212 earlier, which avoids bubbles from remaining in the DC region 212, and improves the coverage effect of the potting liquid on the DC region 212 and the DC electronic components. This provides a tighter encapsulation and protective effect for the bare DC electronic components.

Since most AC electronic components are encapsulated components, the AC electronic components themselves already have high protective properties and relatively low requirements for encapsulation using potting liquid. Therefore, the orthographic projection of the vent port 1121 along the direction perpendicular to the first surface can fall in the AC region 213, that is, directly above the AC region 213 and the AC electronic components. This causes air within the accommodation cavity 130 to gather near the AC region 213 and be discharged from the vent port 1121.

Referring to FIG. 3 and FIG. 5, the power conversion device 10 may further include a connector assembly 400. The connector assembly 400 may include a DC component 410 and an AC component 420. The housing 100 has a mounting side 150. The connector assembly 400 is disposed on the mounting side 150. The distance between the filling port 1111 and the mounting side 150 is less than a predetermined distance. For example, the distance between the filling port 1111 and the mounting side 150 may be less than or equal to 2 mm. It can be understood that the presence of the connector assembly 400 will affect the sealing performance at the mounting side 150 of the housing 100. Therefore, when the distance between the filling port 1111 and the mounting side 150 is less than the predetermined distance, sufficient potting liquid can have ample time to fill a gap between the connector assembly 400 and the housing 100, so that the gap between the connector assembly 400 and the housing 100 can be sealed, and also, the air is allowed to flow out of the area near the mounting side 150 earlier, which can avoid bubbles from remaining in the area near the mounting side 150 and avoid the remained bubbles from affecting potting uniformity, thereby improving the coverage effect of the potting liquid on the mounting side 150, and ultimately improving the sealing performance of the power conversion device 10.

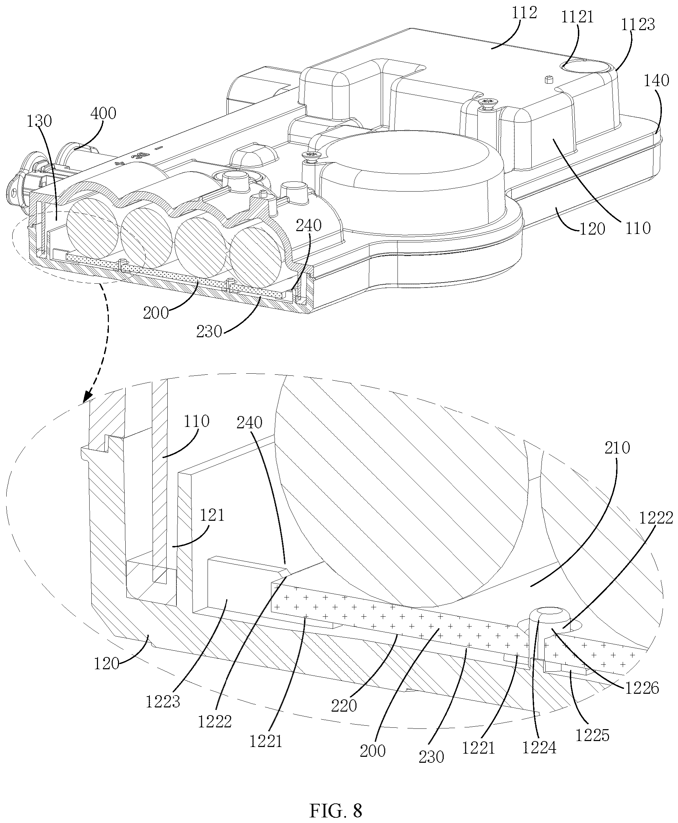

Referring to FIG. 5, FIG. 6, and FIG. 8, in some embodiments, the housing 100 may include a first housing 110 and a second housing 120. The first housing 110 and the second housing 120 collectively enclose the accommodation cavity 130. The filling port 1111 and the vent port 1121 are also disposed in the first housing 110. The circuit board 200 is supported on the second housing 120. The second housing 120 is provided with an annular groove 121. The annular groove 121 is arranged to surround the circuit board 200. During the installation process of the first housing 110 and the second housing 120, a flange on the first housing 110 can cooperate with the annular groove 121. It can be understood that the flange is also annular, allowing the flange on the first housing 110 to be inserted into the annular groove 121. During the assembling process of the power conversion device 10, the flange on the first housing 110 can first cooperate with the annular groove 121. Then, sealing material is accommodated in the annular groove 121. On one hand, it allows the sealing material to seal the annular groove 121 and the accommodation cavity 130. On the other hand, it allows the sealing material to connect the first housing 110 to the second housing 120 to form a complete housing 100. After the housing 100 is assembled, the potting liquid can be injected into the accommodation cavity 130 via the filling port 1111 to encapsulate the entire power conversion device 10. The sealing material may be an adhesive, or the like.

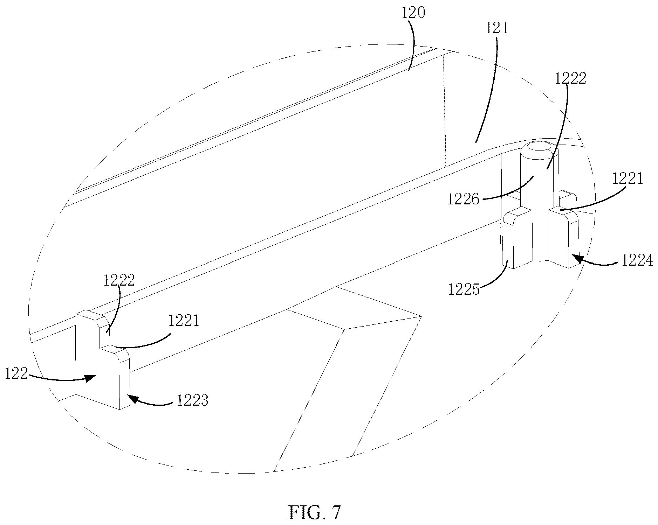

Referring to FIG. 6, FIG. 7, and FIG. 8, in some embodiments, the second housing 120 includes a limiting member 122. The limiting member 122 is configured for supporting the circuit board 200. The limiting member 122 has a first limiting surface 1221 and a second limiting surface 1222. The first limiting surface 1221 and the second limiting surface 1222 are connected at an angle. For example, the first limiting surface 1221 and the second limiting surface 1222 may be perpendicular to each other. The first limiting surface 1221 abuts against the second surface 220 in the direction perpendicular to the first surface, so that the first limiting surface 1221 can support the circuit board 200, and also, a gap 230 is formed between the circuit board 200 and the second housing 120 in the direction perpendicular to the first surface. The second limiting surface 1222 abuts against the circuit board 200 in a direction perpendicular to the direction that is perpendicular to the first surface.

Referring to FIG. 6, FIG. 7, and FIG. 8, for example, the limiting member 122 is an edge limiting member 1223. The edge limiting member 1223 is disposed at an edge of the second housing 120. The second limiting surface 1222 of the edge limiting member 1223 abuts against an edge of the circuit board 200, so that a flow channel 240 in communication with the gap 230 is formed between the edge of the circuit board 200 and the second housing 120. Clearly, this flow channel 240 is arranged to surround the circuit board 200. During the process of the potting liquid flowing into the accommodation cavity 130 via the filling port 1111, the potting liquid located on the side where the first surface 210 of the circuit board 200 is located will enter the gap 230 via the flow channel 240. This allows the potting liquid to enter to the side where the second surface 220 of the circuit board 200 is located, so that the potting liquid can cover the first surface 210 and the second surface 220, and in turn, can cover the entire circuit board 200, ultimately improving the encapsulation effect of the circuit board 200.

Referring to FIG. 6, FIG. 7, and FIG. 8, as another example, the limiting member 122 is a middle limiting member 1224. The middle limiting member 1224 is disposed in the middle of the second housing 120. The middle limiting member 1224 includes a support member 1225 and a post 1226. The post 1226 is disposed in the middle of the support member 1225. One support member 1225 and one post 1226 may be provided. The post 1226 may be inserted into the support member 1225 and protrude relative to the support member 1225. A plurality of support members 1225 may be provided, and one post 1226 may be provided, with the plurality of support members 1225 surrounding the post 1226. The first limiting surface 1221 is an upper surface of the support member 1225. An outer surface of the post 1226 is the second limiting surface 1222. The post 1226 extends through the circuit board 200, such that the post 1226 extends through a hole in the circuit board 200.

Depending on actual needs, the middle limiting member 1224 and the edge limiting member 1223 may be used individually, that is, the second housing 120 includes only the middle limiting member 1224 or only the edge limiting member 1223. The middle limiting member 1224 and the edge limiting member 1223 may also be used at the same time, that is, the second housing 120 includes both the middle limiting member 1224 or only the edge limiting member 1223. There may be a plurality of middle limiting members 1224 and a plurality of edge limiting members 1223.

Referring to FIG. 3 and FIG. 4, in some embodiments, the power conversion device 10 further includes a sealing member 500. The sealing member 500 is configured for sealing the filling port 1111 and the vent port 1121. After the accommodation cavity 130 is completely filled with potting liquid and the potting liquid has been cured, the filling port 1111 and the vent port 1121 can be sealed by the sealing member 500, thereby preventing external dust and liquid from invading the accommodation cavity 130.

Referring to FIG. 3 and FIG. 5, in some embodiments, the power conversion device 10 further includes an indicator light 600. The indicator light 600 includes a light-emitting portion 610 and a sealing portion 620. The light-emitting portion 610 is disposed on the first surface 210. The sealing portion 620 covers the light-emitting portion 610 and is attached to the first surface 210. The sealing portion 620 can provide a protective effect for the light-emitting portion 610, preventing the potting liquid from covering the light-emitting portion 610. The light ray generated by the indicator light 600 can be transmitted out through the housing 100 with light-transmitting properties, or through a light-transmitting hole on the housing 100. Thus, the operating status of the circuit board 200 can be determined based on a light-emitting state of the indicator light 600. Further, the indicator light 600 may also include a light guide column 630. The light guide column 630 is connected to the sealing portion 620. The light guide column 630 is configurated to guide a light signal from the light-emitting portion 610 to an outer surface of the housing 100, allowing the light-emitting state of the indicator light 600 to be tracked more conveniently.

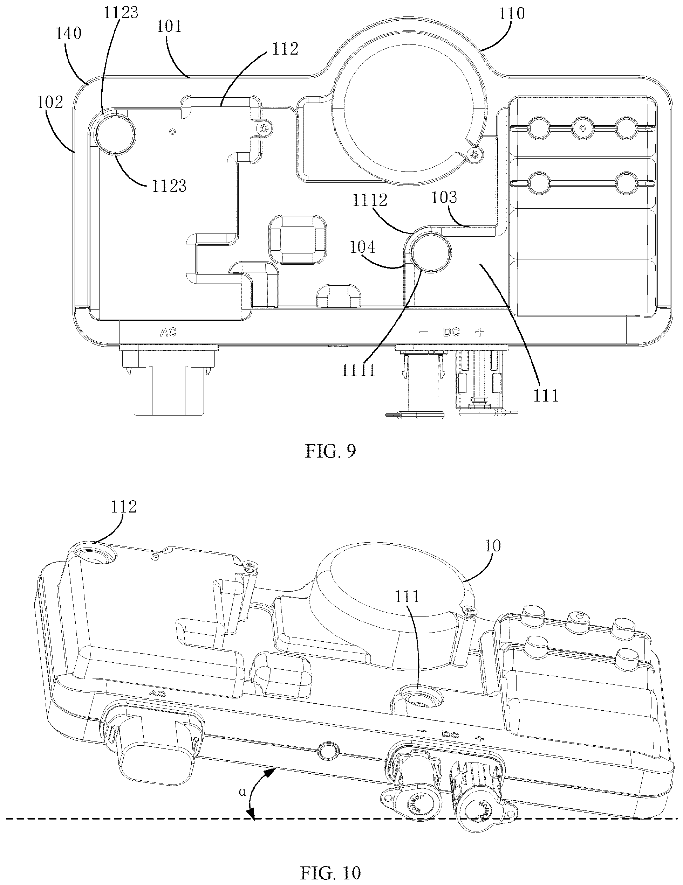

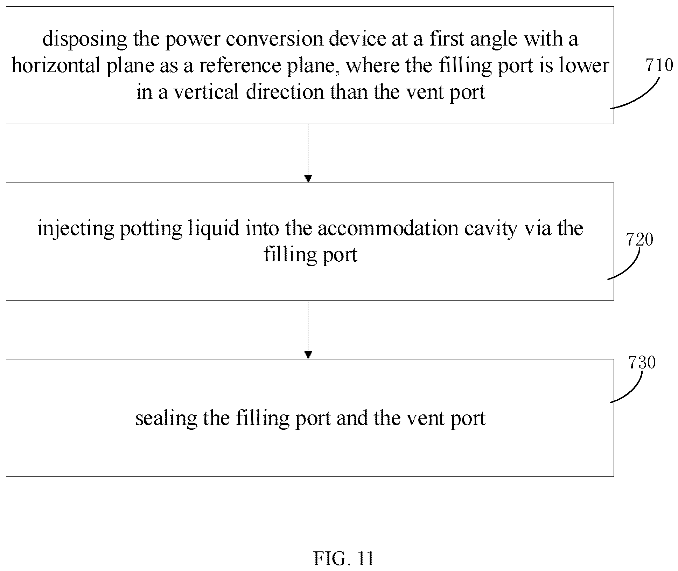

Referring to FIG. 10 and FIG. 11, the present application further provides a manufacturing method for the power conversion device 10. The manufacturing method mainly includes the following steps.

At S710, the power conversion device 10 is disposed at a first angle α with reference to a horizontal plane as a reference plane, where the filling port 1111 is lower in the vertical direction than the vent port 1121.

At S720, the potting liquid is injected into the accommodation cavity 130 via the filling port 1111.

At S730, the filling port 1111 and the vent port 1121 is sealed.

In some embodiments, for example, the power conversion device 10 may be placed horizontally on the horizontal plane. In this case, the value of the first angle α is 0°. For another example, the power conversion device 10 may be obliquely placed on a horizontal plane. In this case, the value of the first angle α is in a range of 15° to 30°. The specific value of the first angle α may be 15°, 20°, or 30°, etc. Certainly, when the power conversion device 10 is tilted, the filling port 1111 has to be lower in the vertical direction than the vent port 1121. By tilting the power conversion device 10, the distance between the vent port 1121 and the filling port 1111 in the vertical direction can be further increased, which further facilitates improving the fluidity of the potting liquid and also facilitates air discharge from the vent port 1121, thereby improving the potting uniformity of the power conversion device 10.

For convenience of description, two opposite long sides of the power conversion device 10 are referred to as a first long side and a second long side, respectively, and two opposite short sides of the power conversion device 10 are referred to as a first short side and a second short side, respectively. During the tilting process, the power conversion device 10 can be fixed by a clamp. For example, the first short side of the power conversion device 10 can be disposed parallel to the horizontal plane, such that the second short side of the power conversion device 10 is higher than the first short side relative to the horizontal plane. In this case, the long side of the power conversion device 10 is disposed at the first angle α with respect to the horizontal plane. FIG. 9 shows the situation where the first short side of the power conversion device 10 is parallel to the horizontal plane. As another example, the first long side of the power conversion device 10 can be disposed parallel to the horizontal plane, such that the second long side of the power conversion device 10 is higher than the first long side relative to the horizontal plane. In this case, the short side of the power conversion device 10 is disposed at the first angle α with respect to the horizontal plane. As yet another example, the portions where the two long sides intersect the short side of the power conversion device 10 can be placed on a clamp, such that each of the long sides and the short sides of the power conversion device 10 can be disposed at the first angle α with respect to the horizontal plane.

In some embodiments, during the process of injecting an adhesive into the accommodation cavity 130 via the filling port 1111, the adhesive can be injected into the accommodation cavity 130 through a one-way valve. The one-way valve has the function of preventing the backflow of the adhesive. For example, the one-way valve is disposed at the filling port 1111. The one-way valve only allows the potting liquid to enter the accommodation cavity 130 from the outside and prevents the potting liquid in the accommodation cavity 130 from flowing out to outside through the one-way valve. This can effectively prevent the potting liquid in the accommodation cavity 130 from overflowing from the filling port 1111, allowing the accommodation cavity 130 to be filled with the potting liquid as quickly as possible, thereby improving potting efficiency and avoiding the waste of the potting liquid.

The various technical features of the above-described embodiments may be combined arbitrarily. To keep the description concise, not all possible combinations of the technical features in the above embodiments have been described. However, as long as there is no conflict in the combination of these technical features, it should be considered as falling within the scope recorded in this specification.

The above-described embodiments merely present several implementations of the present application, and their descriptions are relatively specific and detailed, but should not be understood as limitation on the scope of the patent application. It should be noted that for those ordinary skilled in the art, several variants and improvements can be made without departing from the concept of the present application, and these all fall within the protection scope of the present application. Therefore, the protection scope of the present application shall be subjected to the appended claims.

## Claims

1. A power conversion device, comprising:
a housing enclosing an accommodation cavity, the housing being provided with a filling port and a vent port, wherein the filling port and the vent port are in communication with the accommodation cavity; and
a circuit board disposed in the accommodation cavity, the circuit board having a first surface configured for mounting of electronic components, wherein the filling port is closer to the first surface than the vent port.

2. The power conversion device according to claim 1, wherein the filling port and the vent port are spaced apart by ΔH in a direction perpendicular to the first surface.

3. The power conversion device according to claim 1, wherein the first surface has a blank region with no electronic components mounted thereon, and an orthographic projection of the filling port along a direction perpendicular to the first surface falls within the blank region.

4. The power conversion device according to claim 1, wherein the first surface has a direct current (DC) region and an alternating current (AC) region, wherein the DC region is configured for mounting of direct current (DC) electronic components, the AC region is configured for mounting of alternating current (AC) electronic components; along a direction perpendicular to the first surface, an orthographic projection of the filling port falls within the DC region, and an orthographic projection of the vent port falls within the AC region.

5. The power conversion device according to claim 1, further comprising a connector assembly, wherein the housing has a mounting side configured for mounting of the connector assembly, and a distance between the filling port and the mounting side is less than a first predetermined distance.

6. The power conversion device according to claim 1, wherein the housing has a first corner region where two side edges intersect, and the vent port is disposed adjacent to the first corner region.

7. The power conversion device according to claim 6, wherein the housing is a conformal structure, the conformal structure comprises a first region and a second region, wherein the first region is closer to the first surface than the second region, and the vent port is disposed at a position in the second region adjacent to the first corner region.

8. The power conversion device according to claim 1, wherein the housing is a conformal structure, the conformal structure comprises a first region and a second region, wherein the first region is closer to the first surface than the second region, the filling port is disposed in the first region, and the vent port is disposed in the second region.

9. The power conversion device according to claim 8, wherein the first region comprises a second corner region with a rounded corner, the filling port is disposed adjacent to the second corner region, and the filling port is circular.

10. The power conversion device according to claim 8, wherein the second region comprises a third corner region, and the vent port is disposed adjacent to the third corner region.

11. The power conversion device according to claim 1, wherein a predetermined distance is kept between a center of the filling port and a center of the vent port, and the predetermined distance is in a range of 120 mm to 200 mm.

12. The power conversion device according to claim 1, wherein the housing comprises a first housing and a second housing that collectively enclose the accommodation cavity, wherein each of the filling port and the vent port is disposed in the first housing, and the circuit board is supported on the second housing.

13. The power conversion device according to claim 12, wherein the second housing is provided with an annular groove, wherein the annular groove surrounds the circuit board, and the annular groove cooperates with a flange on the first housing to accommodate sealing material.

14. The power conversion device according to claim 12, wherein the second housing comprises a limiting member configured for supporting the circuit board, wherein the limiting member has a first limiting surface and a second limiting surface that are connected at an angle, the circuit board has a second surface opposite to the first surface; the first limiting surface abuts against the second surface in a direction perpendicular to the first surface to cause a gap to form between the circuit board and the second housing in the direction perpendicular to the first surface; and the second limiting surface abuts against the circuit board in the direction perpendicular to the first surface.

15. The power conversion device according to claim 14, wherein the limiting member is an edge limiting member disposed at an edge of the second housing; the second limiting surface of the edge limiting member abuts against an edge of the circuit board such that a flow channel in communication with the gap is formed between the edge of the circuit board and the second housing.

16. The power conversion device according to claim 14, wherein the limiting member is a middle limiting member disposed in a middle of the second housing, wherein the middle limiting member comprises a support member and a post disposed in a middle of the support member; the first limiting surface of the middle limiting member is an upper surface of the support member, the second limiting surface of the middle limiting member is an outer surface of the post, and the post extends through the circuit board.

17. The power conversion device according to claim 1, further comprising a sealing member configured for sealing the filling port and the vent port.

18. The power conversion device according to claim 1, further comprising an indicator light, wherein the indicator light comprises a light-emitting portion and a sealing portion, wherein the light-emitting portion is disposed on the first surface, and the sealing portion covers the light-emitting portion and is attached to the first surface.

19. The power conversion device according to claim 18, wherein the indicator light further comprises a light guide column, wherein the light guide column is connected to the sealing portion and is configurated to guide a light signal from the light-emitting portion to an outer surface of the housing.

20. The power conversion device according to any one of claims 1 to 19, wherein a diameter of the filling port is less than or equal to a diameter of the vent port.

21. A manufacturing method for processing the power conversion device according to any one of claims 1 to 19, comprising the following steps:
disposing the power conversion device at a first angle with a horizontal plane as a reference plane, wherein the filling port is lower in a vertical direction than the vent port;
injecting potting liquid into the accommodation cavity via the filling port; and
sealing the filling port and the vent port.

22. The manufacturing method according to claim 21, wherein the first angle is 0°.

23. The manufacturing method according to claim 21, wherein the first angle is in a range of 15° to 30°.

24. The manufacturing method according to claim 21, further comprising injecting the potting liquid into the accommodation cavity through a one-way valve.
